Europäisches Patentamt

European Patent Office

Office européen des brevets

(19)

(11) Numéro de publication: **0 110 777**
**A1**

# (12) DEMANDE DE BREVET EUROPEEN

(21) Numéro de dépôt: 83402259.2

(22) Date de dépôt: 23.11.83

(51) Int. Cl.³: **H 01 L 29/743**, H 01 L 29/747, H 01 L 29/08, H 01 L 29/52

(30) Priorité: 25.11.82 FR 8219728

(43) Date de publication de la demande: 13.06.84
Bulletin 84/24

(84) Etats contractants désignés: **AT BE CH DE GB IT LI NL SE**

(71) Demandeur: **CENTRE NATIONAL DE LA RECHERCHE SCIENTIFIQUE (C.N.R.S.), 15, Quai Anatole France, F-75007 Paris (FR)**

(72) Inventeur: **Leturcq, Philippe Lab. d'Automatique et d'Analyse, des Systèmes du C.N.R.S. 7, Av. du Colonel Roche, F-31400 Toulouse (FR)**

(74) Mandataire: **Marquer, Francis, CABINET MOUTARD 35, avenue Victor Hugo Résidence Champfleury, F-78180 Voisins le Bretonneux (FR)**

(54) **Structure de thyristor à allumage intrinsèque et son application à la réalisation d'un dispositif bidirectionnel.**

(57) Thyristor à allumage intrinsèque et à sensibilité aux parasites très réduite dans l'état non conducteur, comprenant une première région d'émetteur (5), une première région de base d'inhibition (3) voisine de ladite première région d'émetteur, une seconde région de base principale (2) et une seconde région d'émetteur (4). La première région d'émetteur est subdivisée en plusieurs premières zones (5) électriquement reliées entre elles par des contacts de cathode (6); la première région de base (3) est subdivisée en plusieurs zones électriquement reliées entre elles par des contacts de gâchette d'inhibition (7), qui sont reliés aux contacts de cathode (6) par des moyens d'interruption (9) permettant de créer un court-circuit gâchette d'inhibition-cathode pour inhiber la faculté d'auto-allumage du thyristor. L'épaisseur et le dopage des régions de base et d'émetteur sont choisis de façon que le thyristor soit auto-allumable à la température ambiante normale par le seul courant capacitif, lors du passage à zéro de la tension alternative d'alimentation.

0110777

- 1 -

STRUCTURE DE THYRISTOR A ALLUMAGE INTRINSEQUE ET SON APPLI-
CATION A LA REALISATION D'UN DISPOSITIF BIDIRECTIONNEL.

L'invention concerne un thyristor sensible et son application à la constitution d'un dispositif bidirectionnel utilisé en relais statique.

Dans cette application, les thyristors traditionnels, qui ne
s'allument pas normalement lorsqu'on applique une tension
alternative entre leur anode et leur cathode sans que leur
gâchette soit elle-même soumise à un potentiel, sauf si la
tension anode-cathode dépasse un certain seuil, ont une
tenue en tension et en courant qui peut être insuffisante
dans le cas où l'on recherche une grande sensibilité de commande.

Il est difficile, en effet, avec les structures de thyristor
traditionnelles d'obtenir une protection suffisante vis à
vis des agents de déclenchement parasites, tels que courants
de fuite de jonctions ou courants de déplacement induits par
des variations rapides de la tension d'anode, sans sacrifier
la sensibilité du dispositif vis à vis d'une commande normale par courant de gâchette. Ce problème d'incompatibilité
entre deux performances également importantes se pose avec
une acuïté particulière dans les structures bidirectionnelles de type "triac". Aussi la sûreté de fonctionnement de
ces structures laisse-t-elle souvent à désirer, notamment
dans les utilisations en relais statique.

On sait qu'un thyristor peut être considéré comme l'équivalent de deux transistors combinés entre eux, l'un de type NPN, l'autre de type PNP, avec une région P et une région N communes et que, en dehors de leur mécanisme naturel d'allumage par courant de gâchette, les thyristors traditionnels connaissent un mécanisme parasite d'allumage qui fait intervenir les courants de fuite des jonctions, pour alimenter ces deux transistors.

Un autre mécanisme possible d'allumage d'un thyristor fait intervenir le courant de récupération des charges stockées dans les jonctions fonctionnant en sens inverse au moment du changement d'alternance de la tension. Ce mécanisme, dont l'importance est proportionnelle au produit de la capacité C des jonctions par le taux de variation $\frac{dV}{dt}$ de la tension, n'intervient normalement que pour provoquer des allumages intempestifs.

Il a été envisagé, notamment dans le brevet français 1.362.724 déposé le 9 Mai 1963 par "FAIRCHILD CAMERA AND INSTRUMENT CORPORATION" pour "Dispositif semi-conducteur commandé par un potentiel de surface", de munir un dispositif semi-conducteur, notamment du type thyristor, de moyens d'établir temporairement un court-circuit gâchette-cathode ou gâchette-anode pour commuter le semi-conducteur en particulier vers l'état bloqué. Le but recherché était de réduire le courant de collecteur à une valeur minimum à l'état bloqué et il n'était pas envisagé d'obtenir l'état conducteur par allumage intrinsèque sous l'effet de la seule variation dV/dt de la tension anode-cathode, celle-ci restant en deçà du seuil de tension susvisé.

Cette dernière remarque s'applique également à la demande de brevet allemand publiée DOS 2945391, déposée par SIEMENS AG, le 9 Novembre 1979, dans laquelle il est précisé par ailleurs que le court-circuit entre les contacts de gâchette et de cathode qui sert à bloquer le thyristor est réalisé en faisant comporter à la région d'émetteur associée à la cathode une pluralité de zones en forme de bandes et en intercalant, entre lesdites bandes, plusieurs électrodes de court-circuit également en forme de bandes, l'ensemble formant une structure "interdigitée" à doigts parallèles.

L'utilisation à diverses fins d'un court-circuit gâchette-cathode pour bloquer un thyristor a été largement décrite dans la littérature. Par exemple, la demande de brevet français 2.331.155 propose de réaliser un thyristor sensible aux rayons lumineux et s'amorçant par la lumière. Pour éviter qu'un allumage parasite ne se produise sous l'action des courants capacitifs, dans le cas où la tension a une vitesse de montée $\frac{dV}{dt}$ trop grande, on réalise, ici encore, un court-circuit entre la gâchette et la cathode.

D'une façon plus générale, pour éviter qu'un allumage parasite ne se produise sous l'action des courants de fuite ou des courants capacitifs, il est bien connu de shunter la jonction gâchette-cathode par une résistance de valeur adéquate, ce qui a d'ailleurs pour effet de rendre le thyristor moins sensible. Cette résistance est le plus souvent intégrée au dispositif même, où elle est, en ce cas, simplement déterminée par la résistance de couche de la base P et des court-circuits de géométrie convenable établis entre l'électrode de cathode et la base P. La résistance de shunt dérive une partie importante du courant de base de la section NPN du thyristor, décalant vers les niveaux de polarisation plus élevés le seuil de conduction autonome. Plus précisément, le courant minimum requis pour déclencher le dispositif est alors approximativement I = Vt/Rs, où Vt est le seuil de conduction pour la jonction émetteur N -base P, de l'ordre de 0,7 V à 300°K, et Rs est la résistance de shunt. L'immunité du dispositif vis à vis des agents de déclenchement parasites peut alors être améliorée par le choix de faibles valeurs pour Rs, de l'ordre de quelques dizaines d'Ohms ; mais cela se fait au détriment de la sensibilité de commande.

D'autres solutions sont également utilisées, comme le branchement en shunt sur l'anode et la cathode d'un réseau RC de protection pour éviter les fluctuations trop rapides de la tension d'anode ; mais cette dernière solution est lourde, coûteuse et d'efficacité limitée.

- 4 -

0110777

Ce même problème de déclenchement intempestif par les courants capacitifs se présente avec encore plus d'acuité lorsque l'on réalise un triac par l'intégration, dans un même cristal, de deux structures de thyristor montées tête-bêche. En effet, le couplage étroit réalisé par l'intégration des deux structures de thyristor dans le même cristal a pour effet que les charges stockées dans les bases de l'une des structures en fin de conduction peuvent provoquer le déclenchement de l'autre si la réapplication de tension sur cette dernière se fait de manière trop rapide.

Plus précisément, dans une utilisation en courant alternatif, lorsqu'une période de conduction s'achève pour l'une des structures, une partie des charges résiduelles peut, par conduction ou diffusion latérale, envahir les bases de l'autre structure, où elle s'ajoute aux charges provenant des zones de transition développées par la croissance de la tension (alternance suivante). Le courant parasite ainsi produit dans les bases de la deuxième structure est donc plus important, pour le même dV/dt, que si les deux structures étaient isolées l'une de l'autre.

L'invention se propose de réaliser une structure de thyristor exempte des inconvénients cités ci-dessus, c'est-à-dire présentant une très grande sensibilité, suffisante pour assurer sa mise en conduction à la température ambiante ordinaire sous le seul effet de l'application de la tension entre anode et cathode, tout en conservant une excellente immunité aux allumages parasites lorsqu'elle doit rester bloquée. Dans une utilisation en courant alternatif, une telle structure de thyristor présente l'originalité essentielle de fonctionner en allumage intrinsèque, c'est-à-dire déclenché spontanément aussitôt que la tension d'alimentation, après passage par zéro, entre dans l'alternance de polarité convenable ; le blocage du dispositif s'obtient en inhibant cette faculté d'allumage intrinsèque par l'établissement d'un court-circuit gâchette-cathode agissant comme commande d'extinction.

L'invention a encore pour objet la réalisation d'un dispositif bidirectionnel constitué de deux thyristors du type susvisé, associés tête-bêche et présentant les mêmes avantages que ledit thyristor, à savoir allumage intrinsèque à température ordinaire et grande insensibilité aux variations rapides de tension dans l'état non conducteur, par suppression de la sensibilité dans cet état.

Le thyristor à allumage intrinsèque et suppression de sensibilité dans l'état non conducteur selon l'invention est caractérisé en ce qu'il comprend essentiellement : une première région d'émetteur, une région de base d'inhibition voisine de ladite première région d'émetteur, une deuxième région de base principale et une seconde région d'émetteur, la première région d'émetteur comportant une zone munie d'un contact de cathode ou plusieurs zones électriquement reliées entre elles par des contacts de cathode, la région de base d'inhibition étant munie de contacts de gâchette d'inhibition, les contacts de gâchette d'inhibition étant reliés aux contacts de cathode par des moyens d'interruption permettant de créer un court-circuit entre gâchette et cathode pour inhiber la faculté d'auto-allumage du thyristor, et lesdites régions de bases et d'émetteur étant réalisées de manière à constituer un thyristor ultra-sensible auto-allumable à la température ordinaire par courant capacitif dû à la seule variation dV/dt de la tension alternative normalement appliquée entre anode et cathode.

Le dispositif bidirectionnel utilisant des structures de thyristors à allumage intrinsèque et à suppression de la sensibilité dans l'état non conducteur selon l'invention, est constitué par deux structures de thyristors conformes à l'invention, réalisées dans un seul cristal semi-conducteur et montées tête-bêche, dont l'anode de la première est reliée à la cathode de la seconde et vice versa et par un circuit électronique de commande de chacun des moyens d'interruption desdites structures de thyristors.

D'autres particularités, ainsi que les avantages de l'invention, apparaîtront plus clairement à la lumière de la description ci-après, faite en se référant au dessin annexé, dans lequel :

La figure 1 est une vue schématique d'un thyristor conforme à un premier mode d'exécution de l'invention ;

La figure 2 représente schématiquement une variante,

La figure 3 est un schéma illustrant l'application de ce thyristor à l'alimentation d'une charge ;

Les figures 4 et 5 représentent, en vue de dessus, des structures d'électrodes à doigts intercalés, respectivement radiaux et en forme de portions de spirales, utilisées dans un tel thyristor ;

Les figures 6, 9, 8 et 10 représentent différentes autres formes d'exécution d'un thyristor conforme à l'invention ;

Les figures 7 et 9 sont des vues de dessus des électrodes de tels thyristors ;

La figure 11 représente un dispositif bidirectionnel réalisé à partir d'un des modes de réalisation dudit thyristor ; et

La figure 12 est une vue schématique d'un circuit de commande d'un tel dispositif bidirectionnel.

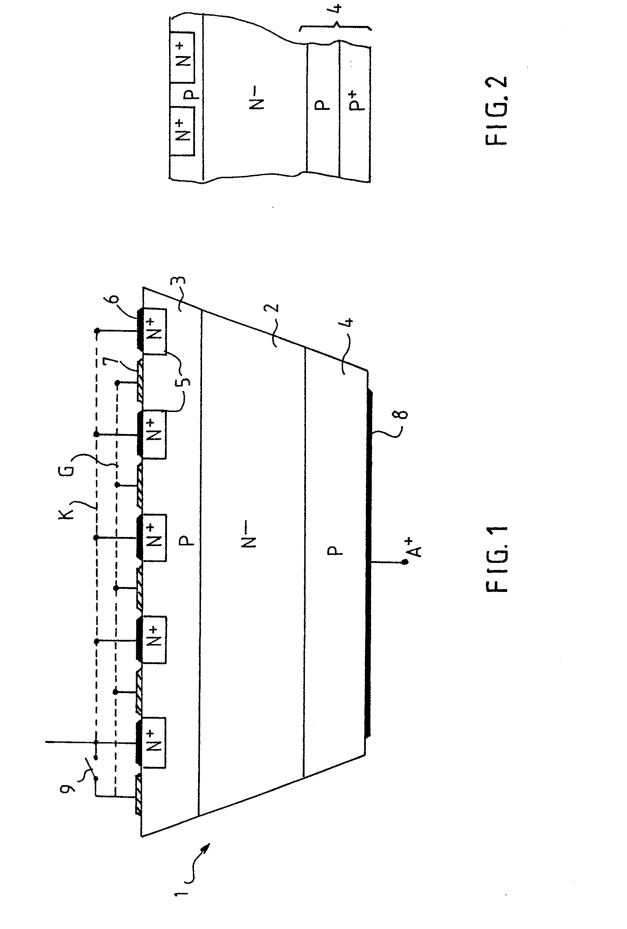

La figure 1 représente la structure d'un thyristor 1 au silicium dont les couches habituelles d'oxyde n'ont pas été représentées, pour plus de clarté.

Une tranche de silicium 2 forme un substrat du type N- faiblement dopé (résistivité forte), de grande qualité et dont les porteurs ont une grande durée de vie.

Pour fixer les idées, le dopage de cette couche 2 correspond, par exemple, à $10^{14}$ atomes/cm$^3$ pour un dispositif de tension blocable 700 volts environ. L'épaisseur initiale de cette couche est de l'ordre de 200 à 300 microns. En mettant en œuvre les techniques de diffusion utilisées pour la fabrication des thyristors ou des transistors bipolaires de puissance, on effectue une diffusion sélective de type P sur les deux faces, de façon à définir deux régions P, repérées 3 et 4. Comme la conductivité de la couche 4 peut être insuffisante pour réaliser un bon contact d'anode, on peut compléter la couche 4 par une diffusion masquée de type P$^+$ à fort dopage sur la face de la couche 4 (voir figure 2), de façon à constituer une couche P$^+$ du côté de l'anode permettant d'améliorer la prise de contacts.

A titre d'exemple, dans cette variante préférée de la figure 2, la couche P pourra avoir un dopage en surface de l'ordre de $10^{18}$ atomes/cm3, alors que la couche P$^+$ pourra avoir un dopage en surface de l'ordre de $10^{20}$ atomes/cm3.

Enfin, une diffusion masquée de type N$^+$ constituera une première région d'émetteur 5. Cette diffusion pourra réaliser un dopage en surface de l'ordre de $10^{20}$ atomes/cm3 par exemple.

On choisira les épaisseurs et les dopages des couches 5 et 3 et leur mode de réalisation, de façon à ce que le gain du premier transistor NPN formé par les couches 5-3-2 soit très élevé. La couche 3 constitue ce que l'on appellera, par la suite, la région de base d'inhibition ; la couche 2, la région de base principale et la couche 4, la seconde région d'émetteur.

Des contacts sont réalisés en fixant des électrodes A (anode), G (gâchette), K (cathode) à des métallisations respectives 8, 7, 6 formées sur les régions 4, 3 et 5.

Il doit être bien compris que, bien qu'on ait décrit des opérations de diffusion, on peut également utiliser d'autres opérations de formation des couches, donnant les valeurs correctes pour la géométrie (par exemple largeur des couches), le dopage (résistivité) et les durées de vie des porteurs : à titre d'exemple, ces opérations peuvent mettre en œuvre les techniques de croissance épitaxiale, d'alliage, et d'implantation ionique.

Dans la structure qui vient d'être décrite, l'invention prévoit que les gains intrinsèques des deux transistors NPN et PNP formés par les couches 5-3-2 et 3-2-4 respectivement doivent être suffisants pour permettre l'auto-amorçage du dispositif dès les faibles niveaux de courants capacitifs (au plus 10 μA par cm2 de surface de jonction), lorsqu'on branche, entre la cathode K et l'anode A, une tension de polarisation V correcte pour que le thyristor devienne conducteur, sous l'effet même de la variation de tension $\frac{dV}{dt}$. Plus précisémment, le produit des gains en courant entre base et collecteur ( $\beta_1$ X $\beta_2$) (ou encore, la somme des gains $\alpha$ ) des transistors constituants, produit qui est normalement une fonction croissante du courant injecté dans les bases (dans le domaine de polarisation considéré), doit être supérieur à l'unité pour des courants de base aussi faibles que le micro-ampère par centimètre carré de surface de jonction. L'allumage du thyristor est bien évidemment consécutif à l'obtention d'un gain de boucle supérieur à l'unité et, dans les conditions qu'on vient d'indiquer, intervient alors même pour de très faibles excitations. Ainsi par exemple, dans un fonctionnement sur réseau alternatif 220 V/50 Hz où le dispositif est périodiquement soumis à des taux de variation dV/dt de la tension d'anode atteignant $10^5$ V/s, pour une capacité C de la jonction centrale (base P⁻ base N⁻) dont la valeur peut être estimée à plusieurs centaines de pF/cm2 dans les cas les plus défavorables, le courant de déplacement C dV/dt, de plusieurs dizaines de μ A/cm2 au passage par zéro de la tension appliquée, dépasse très largement la valeur requise pour amorcer le dispositif. Il s'agit donc d'une structure de thyristor ultra sensible, c'est-à-dire dont le seuil de courant qui définit la sensibilité est situé au voisinage et, de préférence, en deçà de la limite inférieure du seuil de sensibilité des thyristors actuellement considérés comme les plus sensibles. La réalisation d'un tel thyristor ultra-sensible est, en soi, à la portée de l'homme du métier, qui devra, compte tenu des indications qui précédent, faire certains choix et prendre certaines précautions.

En particulier, la durée de vie des porteurs devra être maintenue à une valeur élevée et la passivation des jonctions (réduction des recombinaisons en surface) devra être très soignée. Les choix concernant la profondeur et le dopage de la base N, ainsi que la durée de vie des porteurs, sont évidemment conflictuels en ce qui concerne le gain du transistor PNP et la tenue en tension du dispositif. Toutefois, des compromis satisfaisants peuvent être trouvés jusqu'à des calibres en tension correspondant aux gammes de tensions intéressantes dans les applications envisagées.

A titre d'exemple préféré, mais non limitatif, ces valeurs de compromis sont, pour un dispositif de tension blocable 700 volts environ :

- concentration de la base N................$10^{14}$ atomes/$cm^3$.
- épaisseur de la base N........................... 120 $\mu$ m
- épaisseur de la base P du transistor NPN......... 20 $\mu$ m
- concentration en surface de cette base P,
                         quelques.....$10^{18}$ atomes/$cm^3$.
- profondeur de la diffusion d'émetteur du
                         transistor NPN........ 10 $\mu$ m
- concentration en surface de cette diffusion
                         quelques.....$10^{20}$ atomes/$cm^3$.
- durée de vie des porteurs minoritaires
                         dans la base N............ 25 $\mu$ s

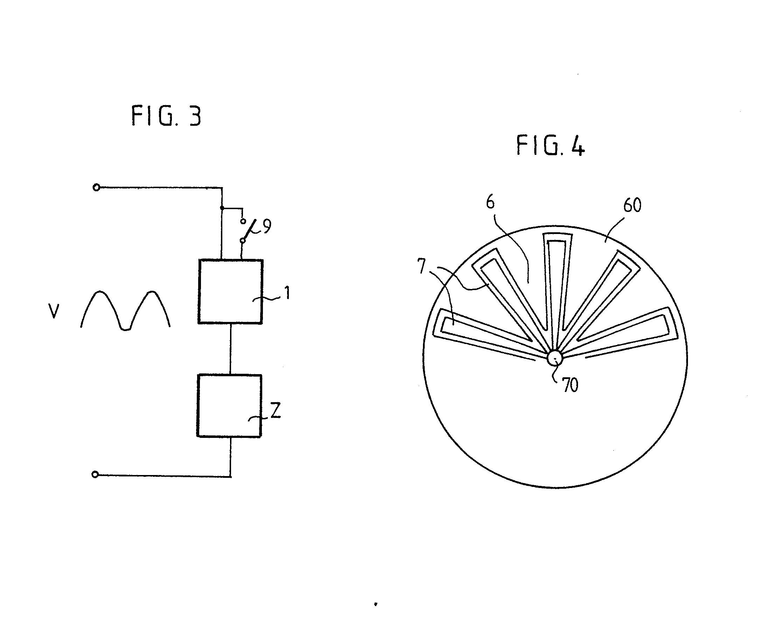

La figure 3 représente le thyristor 1 de la figure 1 ou 2 associé en série avec une charge Z, l'ensemble étant alimenté par une source de tension variable, constituée par exemple par la tension du secteur industriel 50 Hz.

Sur cette figure, on a représenté en 9 un interrupteur matérialisant des moyens de réaliser un court-circuit entre la
gâchette et la cathode du thyristor, par l'application d'une
commande manuelle, pneumatique, électrique, électronique,
optique, thermique, ou autre.

En fonctionnement, lorsque le signal de tension V appliqué
entre la charge et la cathode du thyristor a la polarité
adéquate pour que le thyristor puisse devenir conducteur, si
la pente du front de montée en tension du signal est
suffisante, le thyristor s'amorce intrinsèquement par les
courants capacitifs issus de la zone de transition de la
jonction bloquante 3,2. Il s'éteint naturellement à l'alternance suivante, aussitôt que le courant passant s'inverse.

L'auto-amorçage du dispositif rend inutile la commande traditionnelle par la gâchette. Par contre, pour bloquer le
thyristor et éviter son amorçage intrinsèque par le front de
tension appliqué entre son anode et sa cathode, il est
nécessaire de court-circuiter la cathode avec la gâchette au
moyen de l'interrupteur 9. Ce court-circuit inhibe la sensibilité naturelle du dispositif en déclenchement en dV/dt,
jusqu'à des valeurs très élevées du taux de croissance de la
tension appliquée aux bornes du thyristor.

On notera que, dans l'état bloqué du dispositif, une immunité suffisante vis à vis des agents de déclenchement parasites et, notamment, de la variation dV/dt, ne peut être
obtenue, pour des caractéristiques de couches fixées, que
par une répartition dense des contacts de gâchette d'inhibition ou une géométrie très ramifiée de l'espace gâchette-
cathode, de façon à réduire suffisamment la résistance apparente de shunt de la jonction émetteur 5 - base 7 vis à vis
des courants capacitifs injectés par dV/dt. Ceci sera obtenu
par la réalisation d'un grand rapport périmètre/surface des
zones comprises entre les électrodes 6, 7.

Par exemple, on peut montrer qu'avec les caractéristiques de
diffusion des couches de base P et d'émetteur N précédemment
citées, un rapport périmètre/surface de 100 $cm^{-1}$, ce qui est
facile à réaliser, détermine, pour un court-circuit franc
entre gâchette et cathode, une résistance de shunt interne de l'ordre de quelques centièmes $\Omega$/cm2. Pour une capacité de jonction centrale de quelques centaines de pF/cm2, cet ordre de grandeur de résistance de shunt garantit que le dispositif peut être maintenu bloqué pour des taux de variation dV/dt de la tension d'anode largement supérieurs à 1000 V/$\mu$s (C dV/dt << $V_t/R_S$).

Un des modes d'obtention possibles de ce grand rapport périmètre/surface est la réalisation d'électrodes 6, 7 se présentant sous la forme de doigts intercalés.

La figure 4 représente une forme d'exécution à structure circulaire et à doigts radiaux. L'électrode 7 a la forme de secteurs circulaires radiaux étroits reliés à une zone centrale 70, tandis que l'électrode 6 est constituée de secteurs circulaires complémentaires, également radiaux, reliés entre eux par une région annulaire externe 60 et isolés des secteurs 7.

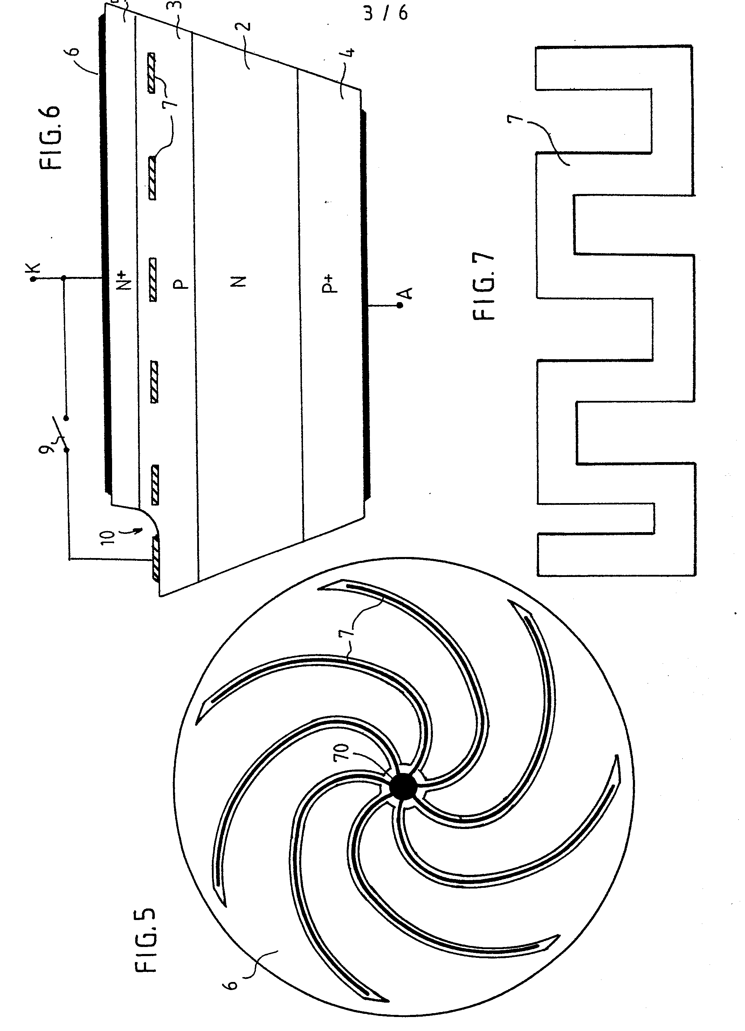

La figure 5 représente une autre forme d'exécution, dans laquelle les électrodes d'inhibition de gâchette 7 ont la forme de portions de spirales issues d'une zone centrale 70, tandis que les électrodes de cathode 6 ont la forme complémentaire.

Les figures 6 et 7 représentent un autre mode de réalisation du thyristor, dans lequel l'électrode de gâchette d'inhibition 7 est réalisée par l'implantation d'une zone continue $P^+$ dans la couche 3 diffusée en matériau P ; la cathode est réalisée par une couche massive 5 de matériau $N^+$ recouverte par une électrode 6 sur pratiquement toute la surface du thyristor. La gâchette n'est accessible, pour l'établissement du contact d'inhibition, que dans une région en décrochement 10 où la couche 5 et une partie de la couche 3 ont été enlevées.

La figure 7 est une vue de dessus de l'électrode de gâchette 7 lorsque l'on a enlevé la couche 5 et la portion de la couche 3 recouvrant l'électrode 7.

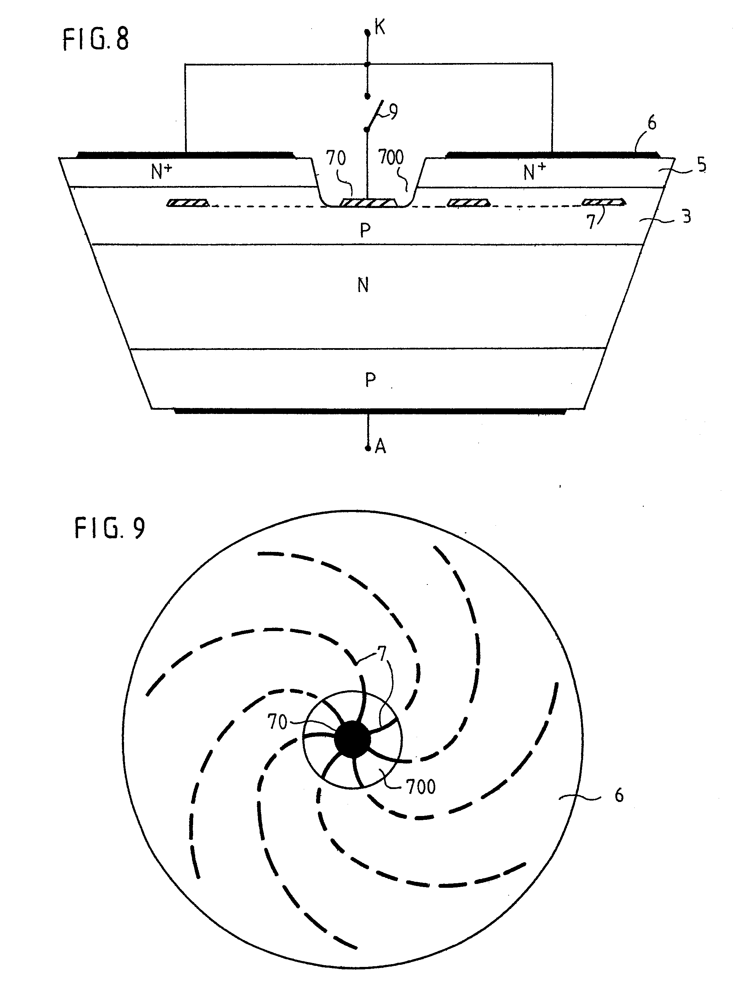

La figure 8 est une vue en coupe d'un thyristor de structure circulaire dans lequel l'électrode de gâchette 7 est implantée dans la couche 3 et affleure dans sa région centrale 700 où la couche 5 et une portion de la couche 3 ont été enlevées. On voit, à la figure 9 que la gâchette 7 de la figure 8 est composée de portions de spirale aboutissant à une zone circulaire centrale 70 et que la cathode 6 est circulaire.

A titre de variante, on pourra encore donner à l'électrode de gâchette d'inhibition 7 la configuration de secteurs circulaires décalés angulairement comme dans la figure 4, mais implantés dans la couche 3, tandis que l'électrode de cathode 6 aura une forme annulaire comme dans le cas de la figure 8. D'autres configurations du type mosaïque pourraient être envisagées également.

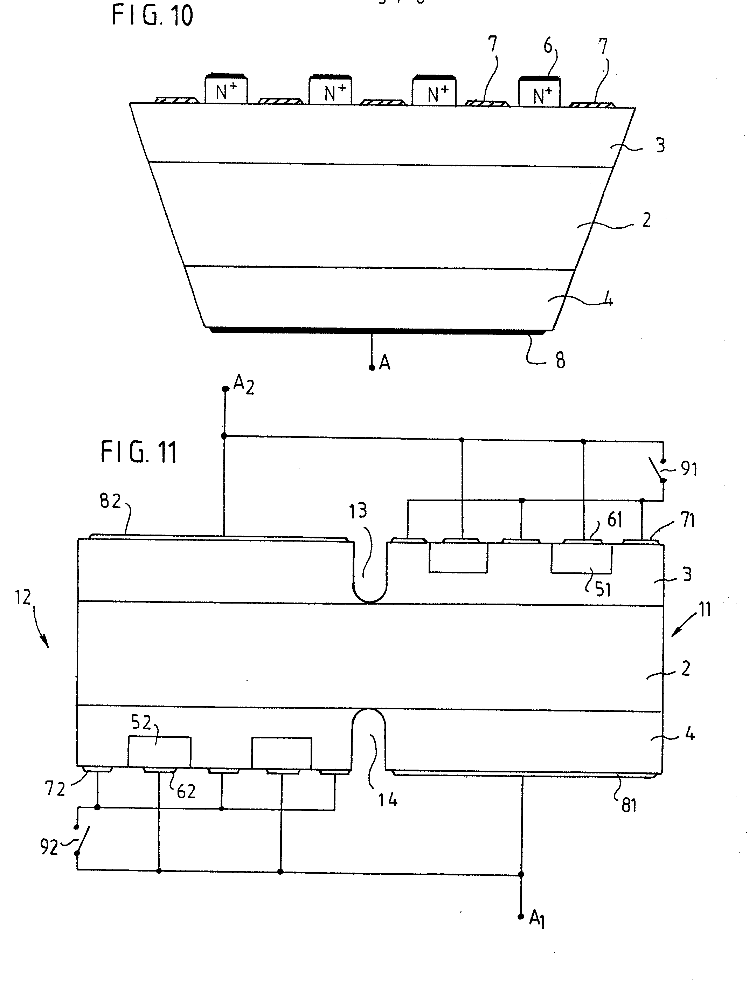

La figure 10 représente une autre forme d'exécution dans laquelle les électrodes de gâchette d'inhibition 7 sont implantées au niveau de la jonction entre émetteur N+ et base P, l'électrode de cathode 6 étant surélevée. Les électrodes 6 et 7 pourront alors avoir la forme de peignes à doigts intercalés.

On notera que, contrairement à ce qu'on observe dans les structures de thyrisor classiques, une telle ramification de la jonction émettrice n'influe guère sur la sensibilité du dispositif et son aptitude à l'armorçage intrinsèque, le court-circuit gâchette-cathode étant simplement interrompu pour commander cet amorçage et la résistance de shunt devenant alors, dans tous les cas, pratiquement infinie.

La figure 11 représente l'association tête-bêche de deux structures de thyristors 11, 12 du type décrit précédemment de façon à former un dispositif bidirectionnel auto-allumable et à allumage inhibé par court-circuit gâchette/cathode. On voit que chacune des structures de thyristors 11-12 est réalisée comme à la figure 1, mais que les couches 2, 3 et 4 sont communes.

L'électrode d'anode 82 du deuxième thyristor est reliée aux électrodes de cathode 61 du premier thyristor et à une borne de sortie A2. Les électrodes de gâchette d'inhibition 71 du premier thyristor 11 sont en haut et reliées aux électrodes de cathode de ce thyristor par un interrupteur 91. L'électrode d'anode 81 du premier thyristor 11 est en bas et reliée aux électrodes de cathode 62 du second thyristor 12, également situées en bas, et à la borne de sortie $A_1$. Les électrodes de gâchette d'inhibition 72 du second thyristor 12 sont en bas et reliées aux électrodes de cathode de ce thyristor par un interrupteur 92.

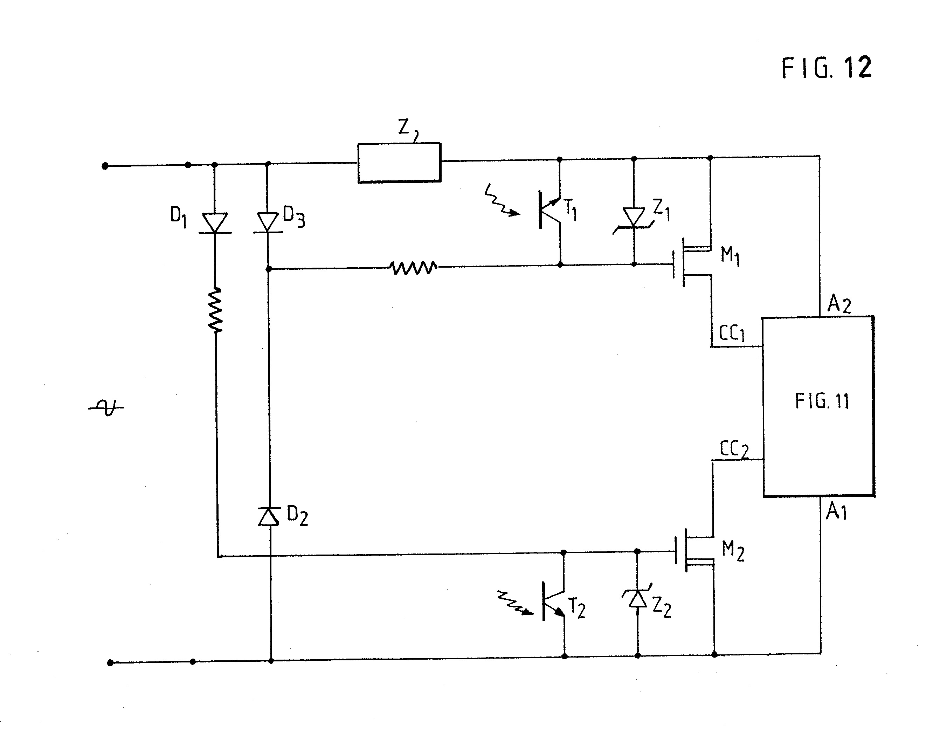

Entre autres utilisations, un tel dispositif bidirectionnel peut remplir une fonction de relais statique en courant alternatif. La figure 12 donne, à titre d'exemple, un schéma de réalisation d'un tel relais où les interrupteurs 91 et 92 de la figure 11 sont constitués par des transistors MOS à effet de champ $M_1$ $M_2$ dont les tensions continues de commande de grille sont fournies, à partir du secteur, par des montages redresseurs simples (diodes $D_1$, $D_2$, $D_3$ et résistances $R_1$, $R_2$), leur niveau étant fixé à la valeur convenable (10 V par exemple), par des diodes de Zener $Z_1$, $Z_2$. Pour la commande du dispositif bidirectionnel, on utilise des phototransistors $T_1$ et $T_2$ qui, lorsqu'ils sont passants, court-circuitent ces polarisations de grille. Ces phototransistors sont eux-mêmes commandés par des diodes électroluminescentes, non figurées.

On notera que dans leur état passant, les transistors MOS ne réalisent jamais un court-circuit franc entre les électrodes de gâchette et de cathode du dispositif bidirectionnel ; la résistance de shunt effective de chacun des thyristors se trouve donc majorée de la résistance apparente drain-source du transistor MOS correspondant. Cette dernière doit évidemment être de valeur inférieure, comparable tout au plus, à la résistance de shunt interne, si on souhaite conserver au dispositif la grande immunité vis à vis des agents de déclenchement parasites, dV/dt notamment, que lui procure sa géométrie de cathode très ramifiée. Cette condition sur la résistance à l'état passant des transistors MOS jouant le rôle d'interrupteurs est en général facile à remplir, même avec des composants bon marché, car les tensions que $M_1$ et $M_2$ ont à supporter entre drain et source sont relativement très faibles, que le relais soit ouvert ou fermé.

En l'absence de signal lumineux de commande, les phototransistors $T_1$ et $T_2$ sont bloqués et les capacités de grille

de $M_1$ et $M_2$ sont chargées, sous alternance positive à travers $D_1$ et $R_1$ pour $M_1$, sous alternance négative à travers $D_2$ et $R_2$ pour $M_2$. Chacune des capacités de grille conserve son état de charge pendant l'alternance suivante, la diode $D_1$ ou $D_2$ correspondante étant alors bloquée, et la diode de Zener $Z_1$ ou $Z_2$ correspondante cessant de conduire aussitôt que la tension à ses bornes devient inférieure à son seuil. Les transistors MOS $M_1$ $M_2$ sont donc passants, de manière permanente et établissent un shunt de faible résistance en $CC_1$-$CC_2$. Le dispositif bidirectionnel est donc bloqué (relais ouvert). La charge est cependant parcourue, pendant l'alternance négative, par le courant circulant dans $D_2$, $R_2$ et $Z_2$, mais celui-ci est normalement de très faible intensité si $R_2$ a une valeur convenable (plusieurs centaines de k$\Omega$ par exemple).

Lorsque les photo-transistors $T_1$, $T_2$ sont activés par un signal lumineux, ils déchargent les capacités de grille des MOS $M_1$ $M_2$ qui se bloquent par conséquent et chacun des thyristors constituant le dispositif bidirectionnel peut alors s'auto-allumer sous l'alternance appropriée de la tension du secteur.

L'interruption du signal lumineux de commande des transistors $T_1$ $T_2$ entraîne leur blocage pratiquement immédiat. La réponse du relais, c'est-à-dire le blocage du dispositif bidirectionnel, est par contre différée d'un délai allant d'environ une demi-période à une période entière, selon que l'alternance au cours de laquelle est donné l'ordre d'ouverture est positive ou négative.

Dans le premier cas, après blocage de $T_1$ et $T_2$, les grilles de $M_1$ et $M_2$ se polarisent au niveau imposé par $Z_1$ et $Z_2$, les charges positives requises à cet effet étant transmises par $D_1$ et $R_1$ d'une part, par $D_3$ et $R_2$ d'autre part. $M_1$ et $M_2$ sont donc commutés dans l'état passant et la voie du dispositif qui n'est pas conductrice sous cette alternance positive se trouve ainsi verrouillée. L'ouverture du relais devient effective dès le début de l'alternance négative suivante, après extinction naturelle de l'autre voie.

Dans le second cas, $D_1$ et $D_3$ sont polarisées en sens inverse, tandis que $D_2$ est très faiblement polarisée, en sens inverse également, par la tension aux bornes du dispositif bidirectionnel, alors conducteur, à travers $Z_2$. Leurs grilles n'étant donc pas alimentées, $M_1$ et $M_2$ restent bloqués et ce n'est qu'à l'alternance positive suivante que débute effectivement le mécanisme d'ouverture. On est ainsi ramené au cas précédent avec un délai supplémentaire pouvant atteindre une demi-période.

Par rapport aux structures de triac classiques, la faculté d'auto-allumage des thyristors constituant la structure de la figure 11, permet de supprimer l'ensemble de la région de commande (gâchette normale et "remote gate"). Dès lors, il n'y a aucune nécessité de maintenir le couplage par proximité des deux thyristors composants, couplage qui est précisément imposé dans les dispositifs actuels par des nécessités de commande et qui est, comme on l'a expliqué plus haut, dommageable à la tenue en dV/dt. Au contraire, les deux régions actives de la structure de la figure 11 peuvent être éloignées l'une de l'autre autant que le permettent les considérations économiques relatives à la taille du cristal : tout couplage par porteurs minoritaires s'estompe dès que la distance transversale entre les émetteurs $N^+$ du premier thyristor et les émetteurs $N^+$ du deuxième dépasse quelques longueurs de diffusion. Des techniques d'irradiation localisée aux électrons peuvent d'ailleurs permettre de parfaire le découplage, sans qu'il soit nécessaire de donner au dispositif des dimensions latérales prohibitives. Dans ces conditions, le concept des court-circuits interruptibles, appliqué aux deux émetteurs N du dispositif, doit assurer, dans l'état bloqué, une immunité vis à vis des agents de déclenchement parasites tout à fait comparable à celle des thyristors conçus comme on l'a indiqué précédemment. Cependant, l'auto-allumage, lorsque les interrupteurs 91-92 sont dans l'état ouvert (ou bloqué) n'est possible que si, à la différence des structures traditionnelles, les régions d'anode ne sont pas confondues avec les bases P, mais, au contraire, électriquement isolées. Des gorges (13, 14) creusées dans le cristal, par attaque chimique par exemple, suffisamment profondes pour atteindre la région 2 en matériau de type N et convenablement passivées, constituent une solution avantageuse de ce problème. Cette particularité mise à part, les choix concernant les géométries d'émetteur et les caractéristiques physiques des couches sont exactement les mêmes que pour les structures de thyristor décrites plus haut.

On soulignera que, dans le dispositif bidirectionnel ou le thyristor que l'on vient de décrire, la tenue en dV/dt reste suffisante, même à des températures plus élevées, alors que, dans ces conditions, la protection des montages classiques par des circuits spéciaux cesse complètement d'être efficace. En effet, les courants de fuite sont en général négligeables vis à vis du courant de déplacement et ce dernier est shunté par un court-circuit qui ne se dégrade pas de manière excessive lorsque la température croît.

Une autre propriété fondamentale des dispositifs de l'invention est la qualité de leur tenue en di/dt, qui permet d'obtenir de bons fonctionnements à l'allumage pour des puissances très élevées. Cette propriété est liée au fait que, dans ces dispositifs, l'allumage intervient à basse tension (au voisinage du zéro) et intervient pratiquement sur toute la surface de la structure à semi-conducteur. Au contraire, dans un thyristor classique à allumage par commande de gâchette, en raison de la présence de shunts d'émetteur permanents propres à la structure, l'allumage est localisé à une tache et la région d'intersection du tube de courant avec la jonction centrale, qui supporte la totalité de la tension du thyristor au début du processus, est soumise à une puissance considérable qui risque d'en provoquer la détérioration.

Il va de soi que diverses autres variantes d'exécution peuvent être conçues et réalisées par l'homme de l'art, sans s'écarter de l'esprit de l'invention.

En particulier, bien que dans les modes d'exécution décrits et représentés, la commande d'inhibition est procurée par un

0110777

court-circuit temporaire entre la région de base P et la région d'émetteur N+, on pourrait envisager de faire comporter en outre au dispositif des moyens d'établir un court-circuit temporaire entre la région de base N- et la région P d'émetteur. Il n'est toutefois pas envisagé en pratique de se contenter de ce dernier court-circuit, le premier étant beaucoup plus efficace.

Revendications de brevet

1. Thyristor à allumage intrinsèque et suppression de sensibilité dans l'état non conducteur, comprenant essentiellement : une première région d'émetteur (5), une première région de base (3) voisine de ladite première région d'émetteur, une seconde région de base (2) et une seconde région d'émetteur (4), la première région d'émetteur étant munie d'au moins un contact de cathode (6) ; la première région de base étant subdivisée en plusieurs zones (7) électriquement reliées entre elles par des contacts de gâchette d'inhibition et au moins un organe d'interruption (9) agencé pour créer un court-circuit entre gâchette et cathode et inhiber ainsi la faculté d'auto-allumage du thyristor, ledit organe d'interruption reliant les contacts de gâchette d'inhibition au(x) contact(s) de cathode, caractérisé en ce que lesdites régions de bases et d'émetteur sont réalisées de manière à constituer un thyristor ultra-sensible auto-allumable à la température ordinaire par courant capacitif dû à la seule variation dV/dt de la tension normalement appliquée entre anode et cathode.

2. Thyristor selon la revendication 1, caractérisé en ce que, ladite tension alternative étant constituée par le réseau 220 V eff, 50 Hz, la réalisation desdites régions d'émetteurs et de bases est telle que la somme des gains dynamiques $\alpha$ des deux sections de transistor qui constituent ledit thyristor, devient supérieure à l'unité pour un courant de déplacement dans la région centrale de l'ordre de 10 $\mu$A/cm2.

3. Thyristor selon la revendication 1 ou 2, caractérisé en ce que, pour un dispositif de tension blocable de l'ordre de 700 volts, la région de base principale a une épaisseur de l'ordre de 120 $\mu$ et un dopage correspondant à une concentration de l'ordre de $10^{14}$ At/cm$^3$ ; la région de base d'inhibition a une épaisseur de l'ordre de 20 $\mu$ et une concentration en surface de l'ordre de $10^{18}$At/cm3 ; la

profondeur de diffusion de la première région d'émetteur est de l'ordre de 10 μ et la concentration en surface de cette diffusion est de l'ordre de $10^{20}$ At/cm3, tandis que la durée de vie des porteurs minoritaires dans la région de base principale est de l'ordre de 25 μ s.

4. Thyristor selon l'une des revendications 1 à 3, caractérisé en ce que la première région d'émetteur est subdivisée en plusieurs zones (5) électriquement reliées entre elles par des contacts de cathode (6) et lesdites zones (5), ainsi que les zones (7) de la première région de base, sont agencées de façon que la résistance apparente de shunt de la jonction émetteur-base correspondante soit de l'ordre de quelques centièmes d'Ohm par centimètre carré de surface.

5. Thyristor selon la revendication 4, caractérisé en ce que la première région d'émetteur (6) et la première région de base (7) sont conformées pour obtenir un rapport périmètre à surface élevée.

6. Thyristor selon l'une des revendications 4 ou 5, caractérisé en ce que la gâchette d'inhibition (7) est réalisée par l'implantation d'au moins une zone (7, figure 7 ou 9) dans la première région de base (3), ladite zone étant accessible, pour l'établissement d'un contact d'inhibition, dans une région en décrochement (10) où la première région d'émetteur (5) et une partie de la première région de base (3) ont été enlevées (figures 6 et 8).

7. Thyristor selon l'une des revendications 4, 5 ou 6, caractérisé en ce que la gâchette d'inhibition (7) a la forme de portions de spirales munies d'une zone centrale commune (70).

8. Thyristor selon l'une des revendications 4, 5 ou 6, caractérisé en ce que la gâchette d'inhibition (7) a la forme de secteurs circulaires étroits disposés radialement à partir d'une zone centrale commune (70).

9. Thyristor selon l'une des revendications 1 à 5, caractérisé en ce que les zones de la première région de base sont réalisées par des contacts situés à la hauteur de la jonction entre la première région d'émetteur et la première région de base (figure 10).

10. Thyristor selon les revendications 2 ou 3, caractérisé en ce que les zones de la première région d'émetteur et de la première région de base sont situées dans le même plan contenant la première région d'émetteur (figure 1).

11. Thyristor selon l'une des revendications 1 à 10, caractérisé en ce que les moyens d'interruption sont constitués par un transistor à effet de champ MOS ($M_1$, $M_2$) dont la grille est polarisée, à partir du secteur, par des montages redresseurs ($D_1$ $R_1$, $D_2$-$D_3$ $R_2$) branchés en série et par des photo-transistors ($T_1$, $T_2$) aptes à court-circuiter ladite polarisation de grille lorsqu'ils sont activés par un signal lumineux.

12. Dispositif bidirectionnel auto-allumable faisant application du thyristor selon l'une des revendications 1 à 11, caractérisé en ce qu'il est constitué par deux thyristors, montés tête-bêche, dont l'anode du premier est reliée à la cathode du second et vice versa.

13. Dispositif selon la revendication 12, caractérisé en ce que chaque première région d'émetteur de l'un des deuxdits thyristors est séparée de chaque deuxième région d'émetteur de l'autre thyristor par un sillon, passivé par glassivation.

FIG. 1

FIG. 2

1 / 6

0110777

FIG. 3

FIG. 4

FIG.5

FIG.6

FIG.7

FIG.8

FIG.9

0110777

FIG. 10

FIG. 11

FIG. 12

0110777

Numéro de la demande

**Office européen
des brevets**

**RAPPORT DE RECHERCHE EUROPEENNE**

EP  83 40 2259

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | US-A-4 060 825  (E.S. SCHLEGEL)<br>* Colonne 2, lignes 3-54 * | 1 | H 01 L  29/743<br>H 01 L  29/747<br>H 01 L  29/08<br>H 01 L  29/52 |
| D,A | DE-A-2 945 391  (SIEMENS AG)<br>* Revendications 1-8 * | 1 | |
| A | EP-A-0 028 799  (SIEMENS AG)<br>* Revendication 1; figure 1 * | 12 | |
| A | US-A-4 092 703  (T. SUEOKA et al.)<br>* Revendication 1; figure 16 * | 1,7 | |
| A | SIEMENS-ZEITSCHRIFT, vol. 47, no. 4, avril 1973, pages 303-305, Erlangen, DE<br>A.   PORST:   "Thyristoren   mit innerer Zündverstärkung" | | **DOMAINES TECHNIQUES RECHERCHES (Int. Cl. 3)**<br><br>H 01 L |
| A | IEEE TRANSACTIONS ON ELECTRON DEVICES, vol. ED-21, no. 8, août 1974, pages 520-522, New York, US<br>H.F.   STORM  et al.: "An involute gate-emitter   configuration   for thyristors" | | |

---

Le présent rapport de recherche a été établi pour toutes les revendications

| Lieu de la recherche<br>LA HAYE | Date d'achèvement de la recherche<br>03-02-1984 | Examinateur<br>ZOLLFRANK G.O. |
|---|---|---|